# EUROPÄISCHE PATENTSCHRIFT

(11) **EP 0 752 590 B1**
(45) Veröffentlichungstag und Bekanntmachung des Hinweises auf die Patenterteilung: **26.05.1999**
(21) Anmeldenummer: 96110343.9
(22) Anmeldetag: 27.06.1996
(51) Int. Cl.: G01R 11/04

(54) **Klemmenblock für Elektrizitätszähler**
Contacts for electricity meter
Plots de contact pour compteur électrique

(30) Priorität: 07.07.1995 DE 19524820; 19.07.1995 DE 19526287; 29.12.1995 DE 19549068; 02.04.1996 DE 19613162; 18.04.1996 DE 19615253
(43) Veröffentlichungstag der Anmeldung: 08.01.1997
(73) Patentinhaber: Industrie-Technik Fröschl GmbH, 93194 Walderbach (DE)
(72) Erfinder: Lottner, Günter, 92431 Neunburg v. Wald (DE); Fröschl, Wilfried, 93152 Etterzhausen (DE)
(74) Vertreter: Graf, Helmut, Dipl.-Ing.

(56) Entgegenhaltungen:
- US-A- 4 104 588
- US-A- 4 121 147

## Beschreibung

Die Erfindung bezieht sich auf einen Klemmenblock für Elektrizitätszähler gemäß Oberbegriff Patentanspruch 1.

Elektrizitätszähler, d.h. Zähler zum Messen bzw. Erfassen des Verbrauchs an elektrischer Energie besitzen üblicherweise einen Klemmenblock, über den die Zähler an die Phasen sowie an den Null-Leiter eines elektrischen Versorgungsnetze anschließbar ist und über den zählerintern die Elemente des Strommeßpfades und des Spannungsmeßpfades, z.B. die jeweilige Stromspule und Spannungsspule angeschlossen sind.

Für jeden gewerblich genutzten Elektrizitätszähler ist vor seiner Verwendung eine Beglaubigungsprüfung vorgeschrieben. Bei dieser Prüfung ist es u.a. erforderlich, den für jede Phase gesondert vorgesehenen Spannungsmeßpfad von dem zugehörigen Strommeßpfad zu trennen, um diesen Spannungsmeßpfad an eine geeichte Spannungsquelle anschließen zu können. Um diese Trennung durchführen zu können, weist die Klemmenanordnung für jede Phase bei herkömmlichen Klemmenblöcken zwischen der Stromklemme und der Spannungsklemme eine elektrische Brücke in Form einer sogenannte Spannungslasche auf, die mit jeweils einer Schraube an der Spannungsklemme und der Stromklemme befestigt ist und für eine elektrische Trennung gelöst werden kann. Um bei der Beglaubigungsprüfung den inneren Spannungsanschluß an die geeichte Spannungsquelle anschließen zu können, sind daher bisher in aufwendiger Weise folgende Schritte nötig:
Lösen der Befestigungsschraube für die Spannungslasche an der Stromklemme;
lösen der Befestigungsschraube für die Spannungslasche an der Spannungsklemme;
zurückziehen der Spannungslasche auf die Spannungsklemme;
sichern der Spannungslasche gegen Verrutschen durch leichtes Wiederanziehen der Befestigungsschraube an der Spannungsklemme.

Erst dann kann eine leitende Verbindung zu der geeichten Spannungsquelle hergestellt werden, und zwar entweder über einen geeigneten Stecker oder aber durch Aufsetzen eines Federstiftes auf die Spannungsklemme.

Am Ende des Prüfvorgangs muß die jeweilige Spannungslasche wieder in ihren Ausgangszustand zurückgebracht werden, d.h. es muß die elektrische Verbindung zwischen der Stromklemme und der Spannungsklemme wieder hergestellt werden, wofür die oben genannten Schritte in umgekehrter Reihenfolge durchgeführt werden müssen.

Der vorgenannte Vorgang ist sehr aufwendig und erfordert auch ein sehr genaues Arbeiten.

Aufgabe der Erfindung ist es, einen Klemmenblock aufzuzeigen, der die Beglaubigungsprüfung wesentlich vereinfacht.

Zur Lösung dieser Aufgabe ist ein Klemmenblock entsprechend dem kennzeichnenden Teil des Patentanspruches 1 ausgebildet.

Bei einer möglichen Ausführungsform des erfindungsgemäßen Klemmenblocks ist die elektrische Verbindung bzw. Brücke zwischen der Stromklemme und der Spannungsklemme der jeweiligen Klemmenanordnung von einem ersten, federnden Kontaktelement gebildet, welches gegen eine an einem zweiten Kontaktelement vorgesehene Anlagefläche anliegt. Die elektrische Brücke kann dann bei einer Ausführungsform der Erfindung in besonders einfacher und auch zuverlässiger Weise dadurch unterbrochen werden, daß das erste Kontaktelement von dem zweiten Kontaktelement federnd weggedrückt und/oder eines der beiden Kontaktelemente so wegbewegt oder weggeschwenkt wird, daß die elektrische Verbindung zwischen beiden Elementen unterbrochen ist. Auch im letzten Fall ist durch die Federwirkung eine zuverlässige Unterbrechung gewährleistet.

Bei einer weiteren möglichen Ausführungsform ist die elektrische Verbindung bzw. Brücke zwischen der Stromklemme und der Spannungsklemme der jeweiligen Klemmenanordnung ebenfalls von einem federnden Kontaktelement gebildet. Dieses wird durch ein Fixierelement gegen eine an dem zweiten Kontaktelement vorgesehene Anlage- bzw. Kontaktfläche angedrückt. Durch Lösen des Fixierelementes schwenkt das federnde Kontaktelement durch seine Federwirkung bzw. durch Entspannen von der Anlage- oder Kontaktfläche weg, so daß wiederum eine zuverlässige Unterbrechung gewährleistet ist.

Bei dem erfindungsgemäßen Klemmenblock ist für die Vorbereitung der Beglaubigungsprüfung allenfalls das Betätigen, z.B. das Lösen eines einzigen Fixierelementes, beispielsweise Schraube, je Phase notwendig. Erfolgt die Unterbrechung durch Wegdrücken des federndes Kontaktelementes, so entfällt auch dieses Lösen eines einzigen Fixierelementes.

Weiterbildungen der Erfindung sind Gegenstand der Unteransprüche.

Die Erfindung wird im Folgenden anhand der Figuren an einem Ausführungsbeispiel näher erläutert. Es zeigen:
- Fig. 1: in schematischer Darstellung und in Draufsicht einen Klemmenblock eines Elektrizitätszählers, wobei lediglich die Klemmenanordnung für eine Phase zusammen mit der Klemme für den Null-Leiter wiedergegeben ist;
- Fig. 2: in vergrößerter Darstellung einen Schnitt entsprechend der Linie 1-1 durch die dortige Klemmenanordnung;
- Fig. 3 und 4: Schnitt-Darstellungen wie Fig. 2 bei einer weiteren möglichen Ausführungsform, und zwar bei geschlossener und geöffneter Kontaktbrücke;
- Fig. 5 und 6: in vereinfachter Darstellung und in Draufsicht eine weitere Ausführung der Klemmenanordnung, und zwar bei geöffneter und geschlossener Kontaktbrücke;
- Fig. 7: eine Seiten-Darstellung, teilweise im Schnitt, der Klemmenanordnung der Fig. 6;
- Fig. 8 und 9: in vereinfachter Darstellung und in Seitenansicht eine weitere Ausführung der Klemmenanordnung, und zwar bei geöffneter und geschlossener Kontaktbrücke;
- Fig. 10 und 11: in vereinfachter Darstellung und in Seitenansicht bzw. in einem Schnitt entsprechend der Linie II-II der Fig. 10 eine weitere Ausführungsform der Klemmenanordnung;
- Fig. 12: in Seitenansicht und teilweise im Schnitt eine weitere Ausführungsform der Klemmenanordnung bei geschlossener Kontaktbrücke;
- Fig. 13 - 16: in unterschiedlichen Ansichten sowie teilweise geschnitten einen Spender, der für die Kontaktelemente, insbesondere der Klemmenanordnung der Fig. 12 geeignet ist;
- Fig. 17: in vergrößerter Detaildarstellung den Kopf des Spenders der Fig. 13 - 16.

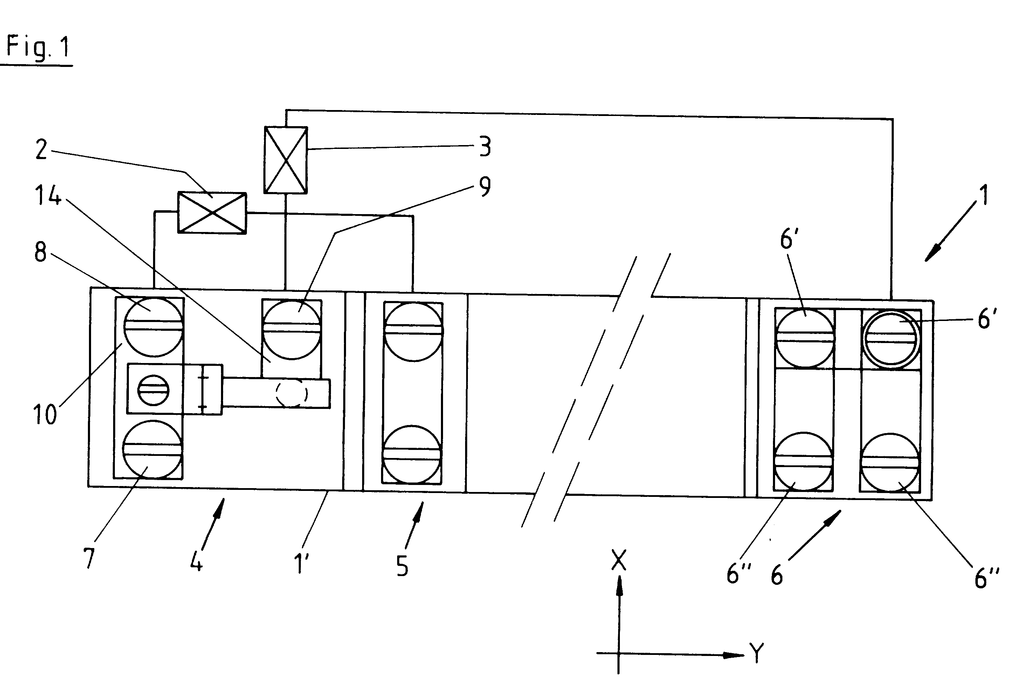

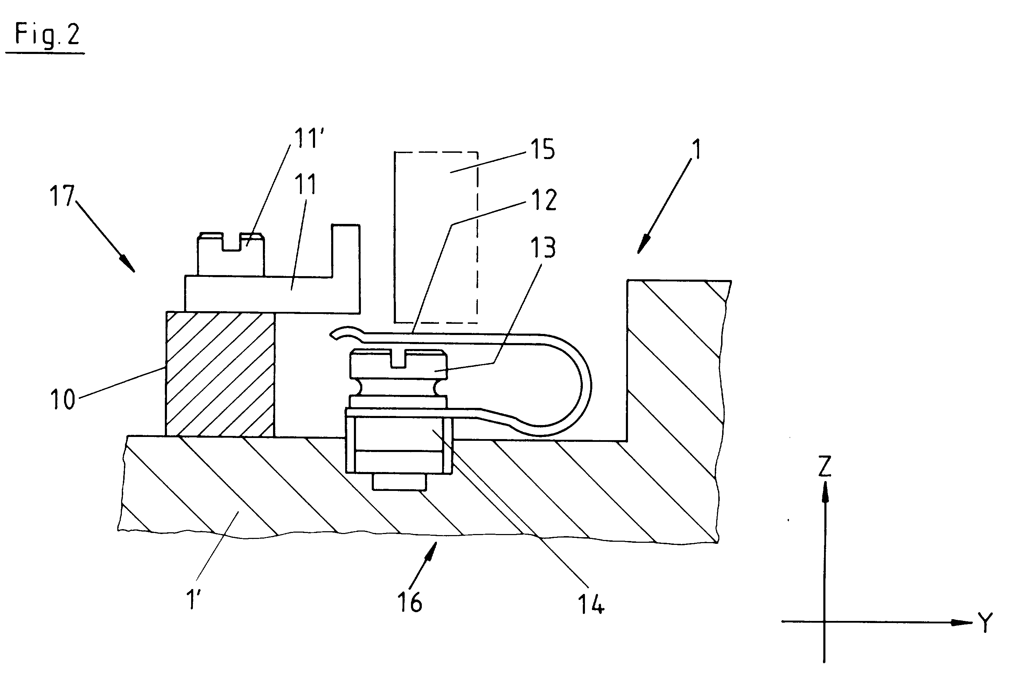

In den Figuren 1 und 2 ist 1 ein Klemmenblock für einen Elektrozähler, nämlich für einen Dreiphasen-4-Leiter-Stromzähler, und zwar zum Anschluß dieses Zählers an das Dreiphasen-Drehstromnetz und an den zugehörigen Null-Leiter. Im Meßwerk werden der fließende Strom und die anliegende Spannung für jede Phase jeweils mittels einer eigenen Spule, nämlich mit der Stromspule 2 und mit der Spannungsspule 3 für die Ermittlung des Energieverbrauchs erfaßt. Beim Einsatz des Zählers sind die beiden Enden der Spule 3 für die Spannung mit der Phase und dem Null-Leiter und dementsprechend mit der Stromklemme der Klemmanordnung 4 für die Phase und der Klemmenanordnung 6 für den Nulleiter verbunden. Die Spule 2 wird von dem Strom der entsprechenden Phase durchströmt und ist dementsprechend mit der Stromklemme der Klemmenanordnung 4 dieser Phase und einer weiteren Stromklemme 5 verbunden, die ebenfalls für jede Phase gesondert vorgesehen ist und zum Weiterführen des durch den Zähler hindurchgeführten Leiters dieser Phase dient.

Für die Beglaubigungsprüfung des Zählers ist es notwendig, die Spannungsspule 3 jeder Phase von der Stromklemme der zugehörigen Phase bzw. Klemmenanordnung 4 zu trennen, um diese Spannungsspule 3 an eine geeichte Spannungsquelle anschließen zu können. Um diese elektrische Trennung vornehmen zu können, weist jede Klemmanordnung 4 insgesamt drei Anschlüsse 7, 8 und 9 auf, von denen die Anschlüsse 7 und 8 die Stromklemme und der Anschluß 9 die Spannungsklemme bilden und von denen der Anschluß 7 zum Anschließen des Zählers an den Leiter einer Phase, der Anschluß 8 zum Anschließen eines Endes der Stromspule 2 und der Anschluß 9 zum Anschließen der Spannungsspule 3 dienen. Die Anschlüsse 7 und 8 sind über einen die Stromklemme bildenden Leiter 10 fest miteinander verbunden. An dem Leiter 10 ist mittels einer Schraube 11' ein seitlich überstehendes Kontakt- und Anschlagelement 11 befestigt, gegen dessen Unterseite ein als gebogene Blattfeder oder Bogenfeder ausgebildetes federndes Kontaktelement 12 mit einem Ende bzw. mit der dortigen Kontaktfläche 12' anliegt, dessen anderes Ende über eine Schraube 13 an einem Leiter 14 gehalten ist, der die Klemme 9 aufweist und die Spannungsklemme bildet.

Über das federnde Kontaktelement 12 ist die Spannungsspule 3 bei betriebsbereitem Zähler mit der Stromklemme 7/8 verbunden. Die Klemmenanordnung 6 besitzt bei der dargestellten Ausführungsform mehrere Anschlüsse 6' und 6". Sämtliche Anschlüsse 6', 6', 7, 8, 9 sowie auch die Anschlüsse der Stromklemme 5 sind von der Vorderseite 17 des Klemmenblocks zugänglich. Mit 1' ist in den Figuren das aus elektrisch isolierendem Material bestehende Gehäuse des Klemmenblocks 1 wiedergegeben, welches im wesentlichen die geschlossene Rückseite 16 dieses Klemmenblocks bildet.

Für die Beglaubigungsprüfung ist es dann lediglich notwendig, beispielsweise die Schraube 11' zu lösen und das als abgewinkelte Lasche ausgebildete Kontaktelement 11 soweit weg zu schwenken, daß das freie Ende des federnden Kontaktelementes 12 außer Eingriff mit dem Kontaktelement 11 kommt und die elektrische Verbindung unterbrochen ist. Mit Hilfe einer speziellen, an der Schraube 13 bzw. an der dortigen Ringnut angreifenden Anschlußklemme (Ohm-Stecker) kann dann die jeweilige Spannungsspule 3 unabhängig von der Phase an die geeichte Spannungsquelle für die Beglaubigungsprüfung angeschlossen werden.

Nach Abschluß dieser Prüfung wird das jeweilige Kontaktelement 11 wieder in seine Ausgangsstellung zurückgeschwenkt und die Schraube 11' festgezogen, so daß das Kontaktelement 12 mit seinem freien Ende wiederum gegen die Unterseite des Kontaktelementes 11 anliegt und damit die elektrische Verbindung zwischen der Klemme 9 und dem Leiter 10 und damit mit dem übrigen Teil der Klemmenanordnung 4 wieder hergestellt ist.

Wie die Figuren 1 und 2 zeigen, sind bei der Klemmanordnung 4 die beiden Anschlüsse 7 und 8 in Richtung der X-Achse gegeneinander versetzt an dem Klemmenblock 1 bzw. an dessen Gehäuse 1' vorgesehen, und der Anschluß 9 in der Y-Achse gegenüber dem Anschluß 8 versetzt. Weiterhin sind auch die einzelnen Klemmenanordnungen 4, 6 und 5 in Richtung der Y-Achse gegeneinander versetzt am Klemmenblock 1 vorgesehen.

Das als Blattfeder ausgebildete Kontaktelement 12 liegt mit einer in Richtung der Z-Achse wirkenden Federkraft mit seinem freien Ende von unten her gegen das Kontaktelement 1 1 bzw. gegen eine von diesem gebildete, der Rückseite 16 zugwandte Kontaktfläche an. Die X-, Y- und Z-Achsen bilden dabei drei senkrecht zueinander verlaufende Raumachsen. Die geschlossene Rückseite 16 und die offene Vorderseite 17 des Klemmenblocks 1 sind jeweils durch die X-Y-Ebene definiert.

Wie in der Fig. 2 mit unterbrochenen Linien angedeutet ist, ist es bei der Beglaubigungsprüfung in besonders einfacher Weise auch möglich, durch einen auf das federnde Kontaktelement 12 von der Vorderseite 17 des Klemmenblocks 1 her in Richtung der Z-Achse einwirkenden Stempel 15 die elektrische Verbindung zwischen den Kontaktelementen 1 1 und 12 zu unterbrechen, so daß ein Lösen der Schraube 11' und ein Wegschwenken des Kontaktelementes 11 bei der Beglaubigungsprüfung entfallen. Hierbei ist es dann auch möglich, den Stempel 15 als Elektrode auszubilden, über die dann nach dem Wegschwenken des Kontaktelementes 12 vom Kontaktelement 11, d.h. nach der Unterbrechung der Verbindung zwischen beiden Kontaktelementen die Spannungsspule 3 für die Beglaubigungsprüfung mit der geeichten Spannungsquelle verbunden wird.

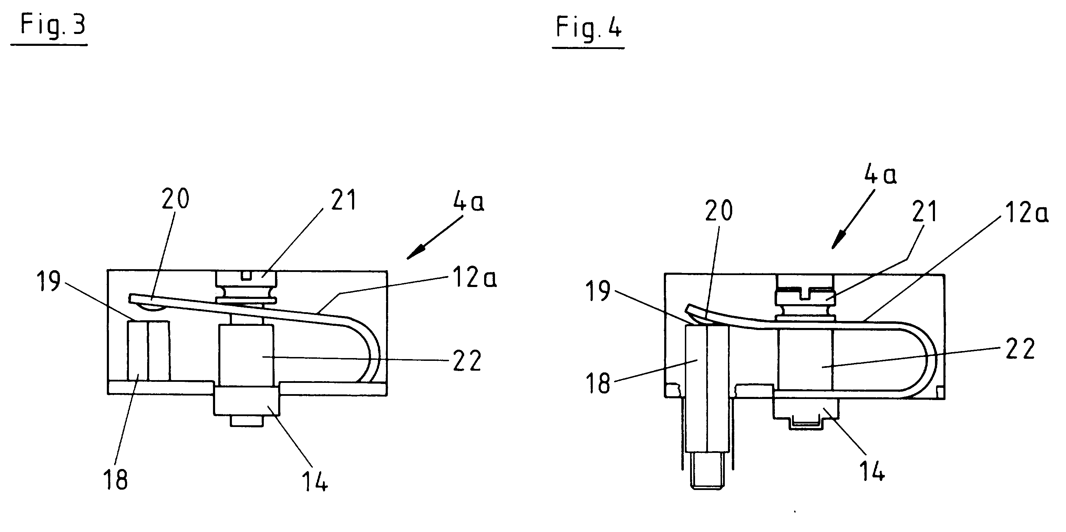

Die Fig. 3 zeigt in ähnlicher Darstellung wie Fig. 2 als weitere mögliche Ausführungsform eine Klemmenanordnung 4a, die sich von der Klemmenanordnung 4 der Fig. 2 lediglich dadurch unterscheidet, daß anstelle des Kontaktelementes 12 ein wiederum als Bogenfeder ausgebildetes Kontaktelement 12a vorgesehen ist, das mit dem Kontaktstift oder -element 18 bzw. mit der an diesem Kontaktelement oben gebildeten und der Vorderseite des Klemmenblockes zugewandten Kontaktfläche 19 zusammenwirkt. Die das Kontaktelement 12a bildende Bogenfeder ist mit seinem in der Fig. 3 unteren Schenkel wieder an dem Leiter 14 in geeigneter Weise befestigt. Das freie Ende des anderen Schenkels wirkt mit dem Kontakt 19 zusammen. Das Kontaktelement 12a bzw. die dieses Kontaktelement bildende Bogenfeder ist so geformt, daß das freie Ende des oberen Schenkels der Feder bzw. die dortige Kontaktfläche 20 im entspannten Zustand der Feder von der Kontaktfläche 19 entfernt ist (Fig. 3), so daß Strommeßpfad und Spannungsmeßpfad getrennt sind. Das Kontaktelement 18 ist an dem Leiter 10 vorgesehen. Das Kontaktelement 18 ist als Kontaktbolzen ausgebildet. Die Kontaktfläche 20 bildet eine Kugelfläche.

Zum Herstellen der Verbindung zwischen dem Strommeßpfad und dem Spannungsmeßpfad wird mittels einer Schraube 21, die etwa in der Mitte des oberen Schenkels des Kontaktelementes 12a angreift, dessen Kontaktfläche 20 unter elastischer Verformung des Kontaktelementes gegen die Kontaktfläche 19 angedrückt. Die Schraube 21 greift mit ihrem Gewinde in ein Innengewinde eines bolzenförmigen Abstandhalters 22 ein, dessen Länge so gewählt ist, daß dann, wenn der oberen Schenkel des Kontaktelementes 12a gegen den Abstandhalter 22 bei vollständig festgezogener Schraube 21 anliegt und somit zwischen diesem Abstandhalter und dem Kopf der Schraube 21 festgeklemmt ist, das die Kontaktfläche 20 aufweisende Ende mit einer ausreichenden Federkraft federnd gegen die Kontaktfläche 19 anliegt, d.h. letztere steht in Richtung der Z-Achse etwas über das Niveau der Anlagefläche des Abstandhalters 22 vor.

Durch den Abstandhalter 22 wird die maximale Verformung des Kontaktelementes 12a beim Schließen der Verbindung zwischen dem Strompfad und dem Spannungspfad begrenzt.

Die Schraube 21 ist mit einem Werkzeug (Schraubenzieher) von der Vorderseite des Klemmenblockes 1 her bequem zugänglich. Zum Trennen der Verbindung wird die Schraube 21 gelöst, wodurch der obere Schenkel des Kontaktelementes 12a unter Entspannung von der Kontaktfläche 19 abhebt.

Vorteile der Klemmenanordnung 4a sind u.a.,
daß nur jeweils eine Schraube 21 gelöst oder festgezogen werden muß daß diese Schraube von der Vorderseite des Klemmblockes bequem zugänglich ist,
daß die Klemmenanordnung in Klemmenblöcke vorhandener Konstruktion eingesetzt werden können, d.h. dort keine konstruktiven Änderungen notwendig sind, und
daß das Festziehen und Lösen der Schraube 21 und damit das Schließen und Öffnen der elektrischen Verbindung im Einhand-Betrieb möglich sind.

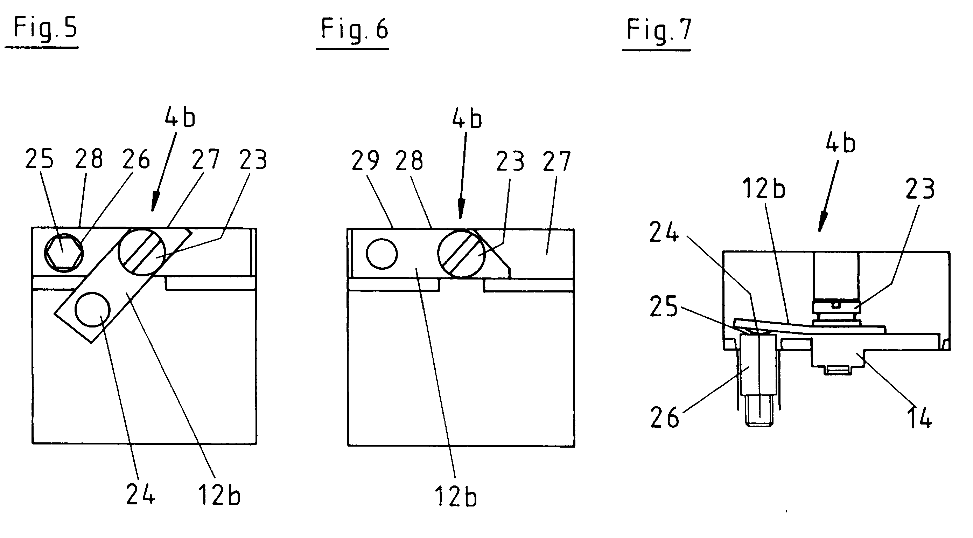

Die Fig. 5 - 7 zeigen als weitere mögliche Ausführungsform eine Klemmenanordnung 4b, welches anstelle eines bogenfederartig ausgebildeten Kontaktelementes ein blattfederartiges Kontaktelement 12b verwendet. Dieses ist an einem Ende mit einer Öffnung für die Schraube 23 versehen, welche durch die Öffnung hindurch in ein Innengewinde eingreift, welches an dem Leiter 14 vorgesehen ist. Das Kontaktelement befindet sich zwischen dem Kopf der Schraube 23 und dem Leiter 14. Am freien Ende bildet das Kontaktelement wiederum eine Kontaktfläche 24, die mit einer Kontaktfläche 25 an einem Kontaktelement oder -bolzen 26 zusammenwirkt, welcher mit dem Leiter 10 verbunden ist.

Die Schraube 23 ist an der gegen das Kontaktelement 12b anliegenden Unterseite ihres Kopfes so ausgebildet, daß eine ausreichende Reibung zwischen der Schraube 23 bzw. deren Kopf und dem Kontaktelement 12b besteht. Bei geschlossener Verbindung zwischen den Kontaktelementen 12b und 26 und bei festgezogener Schraube 23 ist das Kontaktelement 12b zwischen dem Kopf dieser Schraube und dem Leiter eingespannt und zwar derart, daß die Kontaktfläche 24 federnd gegen die Kontaktfläche 25 anliegt. Die Kontaktfläche 25 und auch der Kopf der Schraube sind wiederum der Vorderseite des Klemmenblockes zugewandt, so daß die Schraube 23 von dort leicht zugänglich ist.

Wird die Schraube 23 gelöst, so wird hierdurch das Kontaktelement 12b durch die zwischen dem Kopf der Schraube 23 und diesem Kontaktelement wirkende Reibungskraft bei der für die Fig. 5 und 6 gewählten Darstellung (Draufsicht) im Gegenuhrzeigersinn geschwenkt, und zwar solange, bis die elektrische Verbindung zwischen den Kontaktelementen 12b und 26 unterbrochen ist und das Kontaktelement 12b mit einer dort vorgesehenen Anlagefläche 27 gegen einen Anschlag bzw. Gehäusewand 28 anliegt. Die Anlagefläche 27 ist von einer Schrägfläche an dem der Kontaktfläche 24 entfernt liegenden Ende gebildet. Wird zum Schließen der elektrischen Verbindung die Schraube 23 angezogen, so wird hierbei zunächst das Kontaktelement 12b mitgeschleppt bzw. mitgedreht, und zwar solange, bis die Kontaktflächen 24 und 25 gegeneinander anliegen und die bei diesem Festdrehen und Schwenken vorauseilende Längsseite des Kontaktelementes 12b gegen die Anlagefläche 28 zur Anlage kommt. Bei der dargestellten Ausführungsform schließt diese Längsseite mit der Anlagefläche 27 einen Winkel größer als 90°, vorzugsweise einen Winkel von 135° ein.

Die besonderen Vorteile der Klemmenanordnung 4b sind u.a.,
daß wiederum nur eine Schraube gelöst bzw. festgezogen werden muß,
daß keine Änderungen an der vorhandenen Konstruktion eines Klemmenblockes notwendig sind und
daß das Öffnen und Lösen im Einhandbetrieb möglich ist.

Um die erforderliche Andrückkraft zwischen den Kontaktflächen 11/12', 19 /20 und 24/25 über lange Zeit sicher gewährleisten zu können, ist das Kontaktelement 12, 12a bzw. 12b aus einem Werkstoff, z.B. Federbronze hergestellt, der gute Federeigenschaften sowie gleichzeitig auch eine hohe Leitfähigkeit aufweist. Die Kontaktelemente 12/12a/12b und 11/18/26 sind weiterhin mit einer korrosionsunempfindlichen Beschichtung überzogen, wodurch ebenfalls niedrige Übergangswiderstände über eine lange Zeitdauer eingehalten werden können.

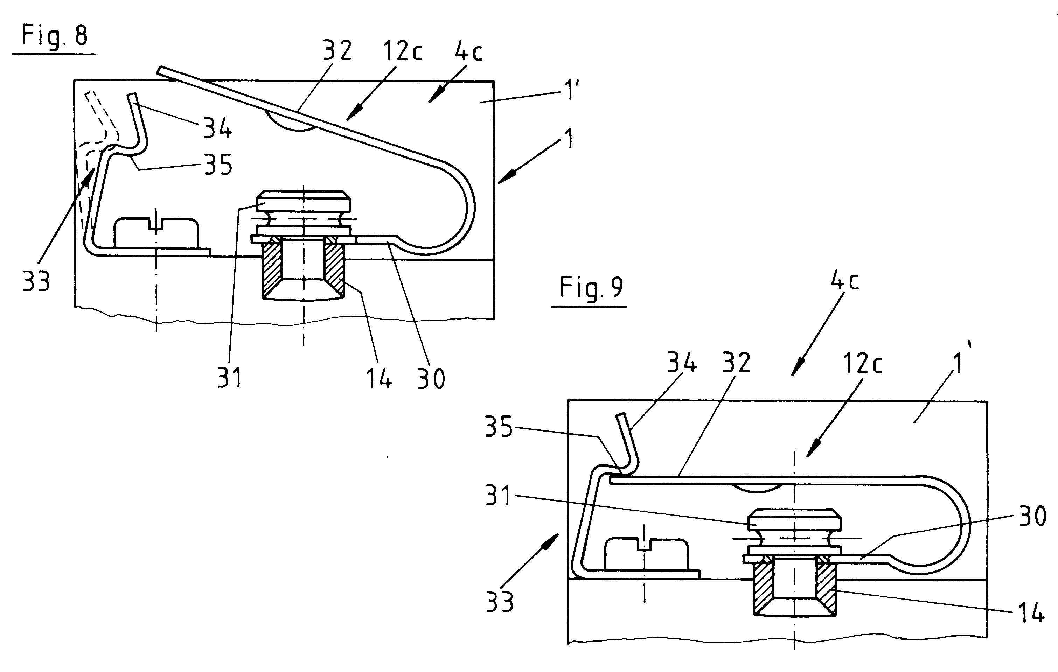

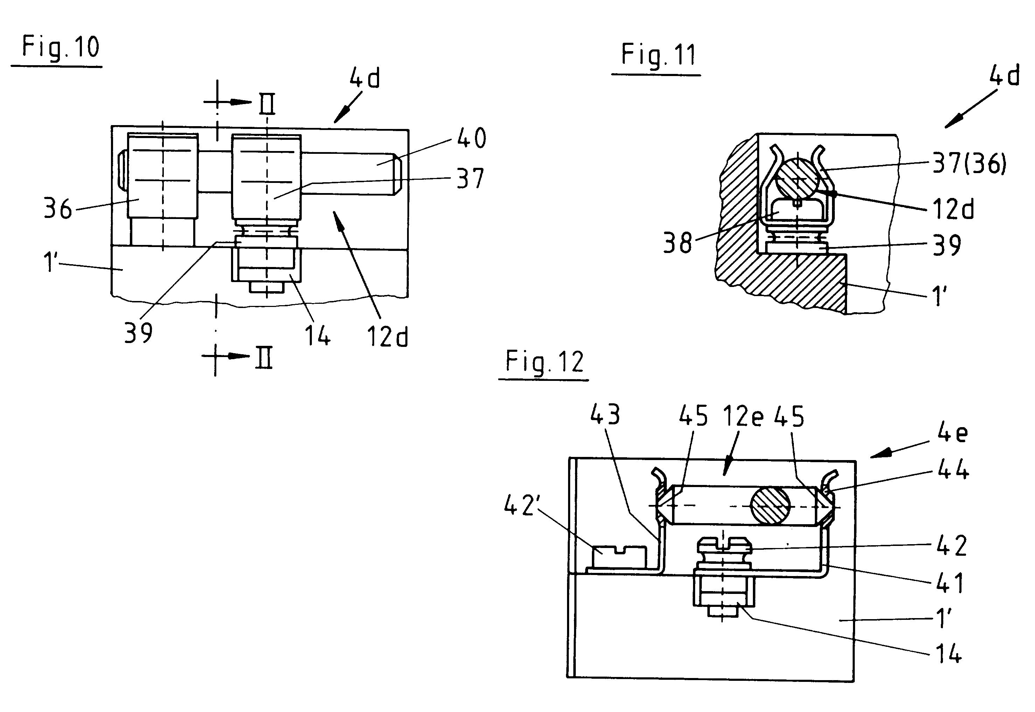

Als weitere mögliche Ausführungsform zeigen die Fig. 8 und 9 eine Klemmenanordnung 4c, die aus dem als Bügelfeder ausgebildeten Kontaktelement 12c besteht, welches mit einem Schenkel 30 über den Niet oder die Schraube 31 mit dem Leiter 14 verbunden und hierdurch auch am Gehäuse des Klemmenblockes gehalten ist.

Freie Schenkel 32 wirkt mit einem blattfederartigen Gegenkontakt 33 zusammen, der mehrfach abgewinkelt und mit einem Ende mittels einer Schraube 34 an dem Leiter 10 befestigt und damit auch am Gehäuse 1' des Klemmenblockes gehalten ist. An seinem freien Ende ist der Gegenkontakt 33 S- oder nasen-förmig umgebogen, so daß dieser Kontakt ausgehend von dem freien Ende einen nasenartigen Abschnitt mit Schrägfläche 34 und daran anschließend eine Kontaktfläche 35 bilden, und zwar derart, daß zum Herstellen der Verbindung zwischen dem Kontaktelement 12 und dem Gegenkontakt 33 der freie Schenkel nach unten gedrückt wird und hierbei an der Schrägfläche 34 gleitet, und zwar unter Zur-Seite-Drücken des als Blattfeder ausgebildeten Gegenkontaktes 33, bis schließlich das freie Ende des Schenkels 32 an der Fläche 35 einrastet (Fig. 9) und damit das als Bügelfeder ausgebildete Kontaktelement 12c mit dem freien Ende des Schenkels 32 an der Rastnase des Gegenkontaktes 33 eingerastet federnd gegen die Fläche 35 anliegt. Das Öffnen der Kontaktbrücke ist durch einfaches Zur-Seite-Drücken des blattfederartig wirkenden Gegenkontaktes 33 oder durch Niederdrücken des Schenkels 32 möglich.

Die Fig. 10 und 11 zeigen als weitere Ausführungsform eine Klemmenanordnung 4d, bei der am Leiter 10 und an dem Leiter 14 jeweils ein klemmbügelartiger Kontakt 36 bzw. 37 vorgesehen ist, wobei der Kontakt 37 mittels einer Schraube 38 und einer Hülse 39 am Leiter 14 befestigt ist. Die Schraube 38 ist durch die Hülse 39 hindurchgeführt. Der Joch-Bereich des U-förmigen Kontaktes 37 ist zwischen dem Kopf der Schraube 38 und der Hülse 39 festgeklemmt, die sich ihrerseits auf dem Leiter 14 abstützt. Als Kontaktelement 12d ist ein Metallstab vorgesehen, der eine hohe elektrische Leitfähigkeit aufweist und zum Schließen der Kontaktbrücke in beiden Kontakten 36 und 37 gehalten ist. Zum Öffnen der Kontaktbrücke kann das Kontaktelement 12d leicht entfernt werden, da dieses mit einer größeren Länge über die dem Kontakt 36 abgewandte Seite des Kontaktes 37 wegsteht und an dieser Länge leicht von einem entsprechenden Werkzeug erfaßt werden kann.

Die Fig. 12 zeigt als weitere Ausführungsform eine Klemmenanordnung 4e, bei der mit dem Leiter 14 ein als Blattfeder ausgeführtes Kontaktelement 41 über die Schraube 42 verbunden ist. Mit dem Leiter 10 ist über eine Schraube 42' ein ebenfalls als Blattfeder ausgebildeter Gegenkontakt 43 verbunden. Beide Kontakte 41 und 43 besitzen an den freien Enden ihrer einander zugewandten Schenkel jeweils eine trichterartige Öffnung 44, in welche jeweils ein kegelstumpfförmig ausgebildetes Ende 45 des auch bei dieser Ausführungsform wiederum stabförmig ausgeführten Kontaktelementes 12e eingesetzt werden kann. Durch Entfernen des Kontaktelementes 12e kann die Kontaktbrücke geöffnet werden.

Die an dem Leiter 14 vorgesehenen Schrauben 13, 21, 23, 31 und 42 und die Hülse 39 sind jeweils mit einer Ringnut versehen, die den Anschluß des sog. ,,Ohm-Steckers" bei der Prüfung, insbesondere Beglaubigungsprüfung ermöglicht. Die Klemmenanordnung 4, 4a, 4b, 4c, 4d, 4e zeichnen sich durch geringe Kosten sowie auch dadurch aus, daß der Umbau von neu zu beglaubigenden Zählern problemlos möglich ist.

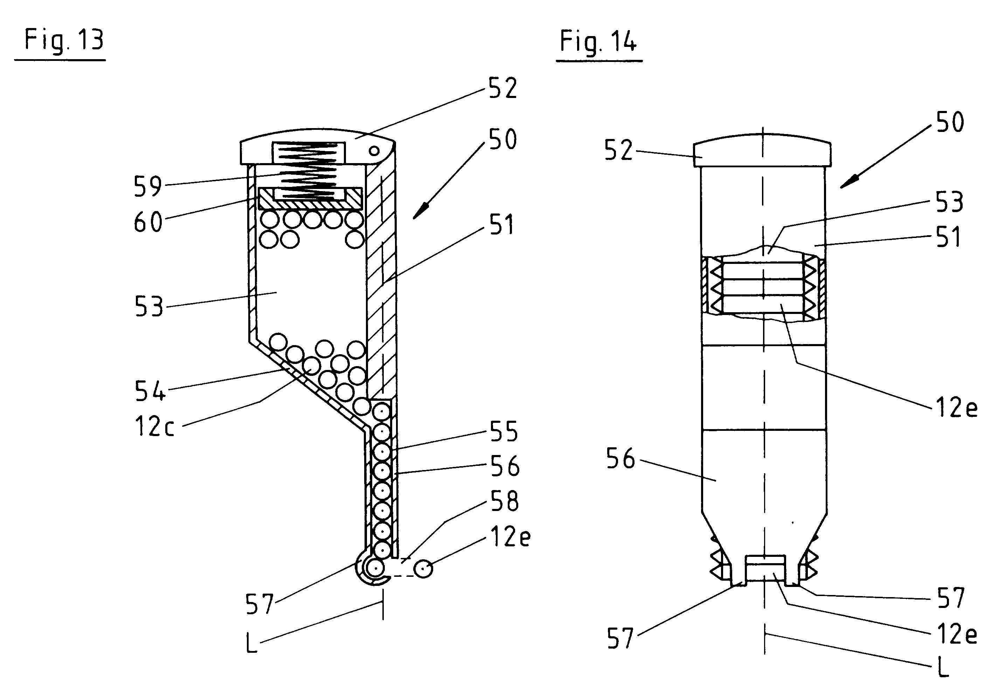

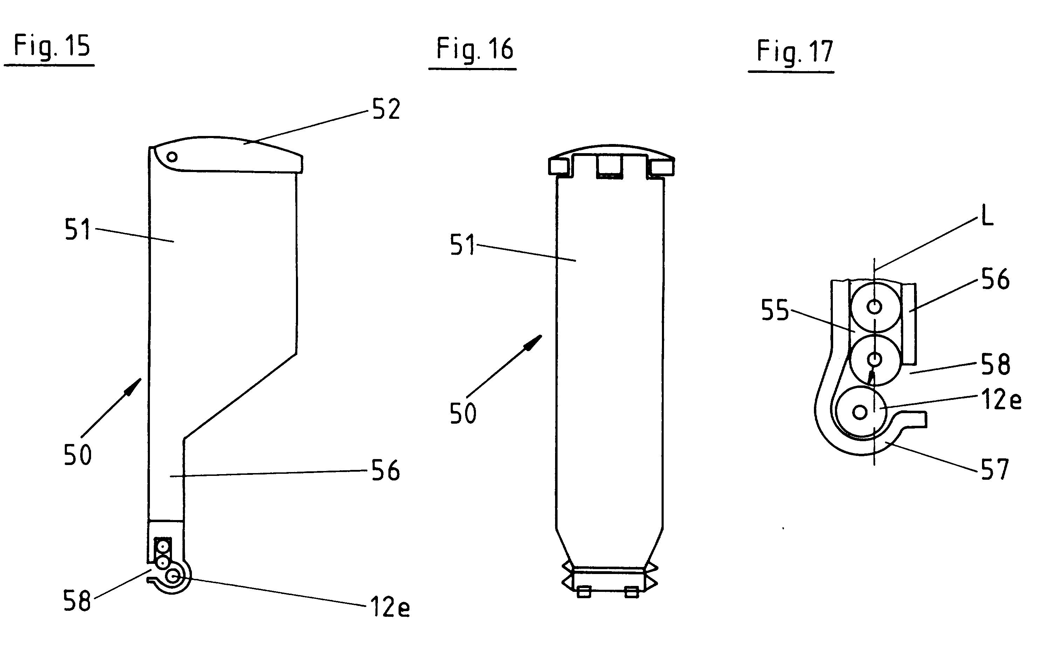

Die Fig. 13 - 17 zeigen einen Spender 50, der insbesondere für den Klemmenblock 4e der Fig. 12 bzw. für die Abgabe und das Einsetzen der dortigen stabförmigen Kontaktelemente 12e geeignet ist. Der Spender 50 kann aber auch für andere stabartige Kontaktelemente, z.B. Kontaktelemente 12d, sowie ganz allgemein zur Abgabe und zum Einsetzen von zylinderförmigen elektrischen Bauelementen in Klemmenanordnungen dienen.

Der Spender 50 besteht aus einem aus elektrisch isolierenden Material, vorzugsweise aus Kunststoff hergestellten Gehäuse 51, welches im oberen Bereich einen durch einen Deckel 52 verschließbaren Innenraum 53 bildet, der zur Aufnahme einer Vielzahl von Kontaktelementen 12e geeignet ist, und zwar derart, daß sämtliche Kontaktelemente 12e jeweils mit ihren Achsen parallel zueinander und mit ihren Umfangsflächen aneinander anliegend im Innenraum 53 angeordnet sind. Der Innenraum 53 besitzt hierfür einen rechteckförmigen oder quadratischen Querschnitt. Weiterhin besitzt der Innenraum 53 eine schräge Bodenfläche 54, an der der Innenraum 53 in einen Auslaß-Schacht 55 übergeht. Der Schacht 55 besitzt einen Querschnitt derart, daß in diesen Schacht die Kontaktelemente 12e eine einspurige Reihe bilden, in der die Kontaktelemente in Längsrichtung L des Schachtes unmittelbar aneinander anschließen und mit ihren Achsen senkrecht zur Längserstreckung L der Reihe orientiert wird. Der Schacht 55 ist an einem über der Unterseite des Kunststoffgehäuses 51 geradlinig und rüsselartig wegstehenden Gehäuseabschnitt 56 gebildet. Am unteren Ende ist der Gehäuseabschnitt 56 seitlich abgeschrägt und offen, so daß die Kontaktelemente 12e dort zunehmend mit ihren beiden Enden seitlich aus dem Gehäuseabschnitt 56 wegstehen.

Am unteren, dem Innenraum 53 entfernt liegenden Ende bildet der Gehäuseabschnitt 56 zwei ösenartige Auflagen 57, die in Längsrichtung der Kontaktelemente 12e versetzt angeordnet sind und die Auflage für das unterste Kontaktelement 12e bilden. Weiterhin ist im Bereich der Auflagen 57 eine Spenderöffnung 58 vorgesehen, deren Breite gleich oder in etwa gleich dem Durchmesser eines Kontaktelementes 12e ist, so daß das jeweils unterste Kontaktelement 12e in einer Achsrichtung radial zur Achse dieses Kontaktelementes und senkrecht zur Längserstreckung L des Schachtes 55 aus dem unteren Ende dieses Schachtes herausgezogen werden kann. Die Anordnung ist weiterhin so getroffen, daß ausgehend von dem unteren Ende des Schachtes 55 bzw. von den dortigen Auflagen 57 das zweite sowie auch alle weiteren Kontaktelemente 12e sicher im Schacht 55 gehalten sind und das unterste Kontaktelement aus den Auflagen 57 nur dadurch entnommen werden kann, daß dieses unterste Kontaktelement 12e und mit diesem auch alle übrigen, im Schacht 55 befindlichen Kontaktelemente 12e etwas relativ zum Schacht bzw. zum Gehäuseabschnitt 56 angehoben werden.

Das Einsetzen des jeweiligen Kontaktelementes 12e in die beiden blattfederartig ausgebildeten Kontakte 41 und 43 erfolgt derart, daß mit Hilfe des Spenders 50 das unterste, im Schacht 55 bzw. an den dortigen Auflagen 57 anliegende Kontaktelement 12e mit den beiden kegelförmigen Enden 45 in die Öffnungen 44 der Kontakte 41 und 43 eingesetzt wird. Anschließend wird dieses Kontaktelement durch seitliches Wegbewegen des Spenders bzw. des Gehäuseabschnittes 56 aus dem Schacht 55 herausbewegt, so daß das Kontaktelement 12e dann in der in der Fig. 12 dargestellten Weise montiert ist. Um sicherzustellen, daß jeweils eine ausreichende Menge an Kontaktelementen 12e im Schacht 55 vorhanden ist und die Kontaktelemente weiterhin in den Schacht 55 nachgefördert weden, ist an der Innenseite des Deckels 52 über eine Feder 59 eine Druckplatte 60 vorgesehen, die gegen die obersten Kontaktelemente 12e anliegt und diese für eine Bewegung in den Schacht 55 vorspannt.

Wie oben bereits ausgeführt wurde, kann der Spender auch für die Kontaktelemente 12d sowie allgemein für zylindrische elektrische Bauelemente, beispielsweise Sicherungen verwendet werden, die in federnde Kontaktanordnungen usw. eingesetzt werden sollen.

Die Erfindung wurde voranstehend an einem Ausführungsbeispiel beschrieben. Es versteht sich, daß zahlreiche Änderungen sowie Abwandlungen möglich sind, ohne daß dadurch der der Erfindung zugrundeliegende Erfindungsgedanke verlassen wird.

### Bezugszeichenliste

- 1: Klemmenblock
- 1': Gehäuse
- 2, 3: Spule
- 4, 4a, 4b: Klemmenanordnung
- 4c, 4d, 4e: Klemmenanordnung
- 5, 6: Klemmenanordnung
- 6', 6", 7, 8, 9: Anschluß
- 10: Leiter
- 11': Schraube
- 11: Kontaktelement
- 12, 12a, 12b: Kontaktelement
- 12c, 12d, 12e: Kontaktelement
- 12': Kontaktfläche
- 13: Schraube
- 14: Leiter
- 15: Stempel
- 16: Rückseite
- 17: Vorderseite
- 18: Kontaktelement
- 19, 20: Kontaktfläche
- 21: Schraube
- 22: Abstandhalter
- 23: Schraube
- 24, 25: Kontaktfläche
- 26: Kontaktelement
- 27: Anlagefläche
- 28: Anschlag
- 29: Anlagefläche
- 30: Schenkel
- 31: Niet oder Schraube
- 32: Schenkel
- 33: Gegenkontakt
- 34: Schrägfläche
- 35: Kontakt- oder Rastfläche
- 36, 37: Kontakt
- 38: Schraube
- 39: Hülse
- 40: freies Ende
- 41: Kontakt
- 42, 42': Schraube
- 43: Gegenkontakt
- 44: Öffnung
- 45: Kegelende
- 50: Spender
- 51: Gehäuse
- 52: Deckel
- 53: Gehäuseinnenraum
- 54: Gehäuseboden
- 55: Schacht
- 56: Gehäuseabschnitt
- 57: Auflage
- 58: Spenderöffnung
- 59: Feder
- 60: Druckplatte

## Patentansprüche

1. Klemmenblock für Elektrizitätszähler, mit wenigstens einer Klemmenanordnung (4), die eine Stromklemme (7, 8) zum Anschließen des Zählers an einen Leiter einer Phase eines elektrischen Versorgungsnetzes sowie zum Anschließen eines Strompfades (2) eines Meßwerkes des Zählers und eine Spannungsklemme (9) zum Anschließen eines Spannungspfades des Meßwerkes aufweist, wobei die Spannungsklemme (9) über eine von einer Vorderseite (17) des Klemmenblocks zugängliche, lösbare Kontaktbrücke (11, 18, 26, 12, 12a, 12b, 12c, 12d, 12e) mit der Stromklemme (7, 8) verbunden ist, **dadurch gekennzeichnet,** daß die lösbare Kontaktbrücke wenigstens ein als Federelement ausgebildeten Kontaktelement (12, 12a, 12b, 12c, 37, 36, 41, 43) aufweist.

2. Klemmenblock nach Anspruch 1, dadurch gekennzeichnet, daß die lösbare Kontaktbrücke von wenigstens einem als Federelement ausgebildeten ersten Kontaktelement (12, 12a, 12b) gebildet ist, welches mit seinem freien Ende gegen eine an einem zweiten Kontaktelement (11, 18, 26) vorgesehene Kontaktfläche anliegt, wobei eines der beiden Kontaktelemente (11, 18, 26, 12, 12a, 12b) mit der Stromklemme (7, 8) und das andere Kontaktelement mit der Spannungsklemme (9) verbunden ist.

3. Klemmenblock nach Anspruch 1 oder 2, dadurch gekennzeichnet, daß das als Federelement ausgebildete erste Kontaktelement (12, 12c) an einer der Vorderseite (17) des Klemmenblocks (1) abgewandte Kontaktfläche (11, 35) anliegt.

4. Klemmenblock nach Anspruch 1 oder 2, dadurch gekennzeichnet, daß das als Federelement ausgebildete erste Kontaktelement (12a, 12b) an einer der Vorderseite (17) des Klemmenblocks (1) zugewandte Kontaktfläche anliegt.

5. Klemmenblock nach einem der Ansprüche 1 - 4, dadurch gekennzeichnet, daß das erste Kontaktelement (12, 12a, 12b, 12c) bogenfederartig ausgeführt ist oder eine Bogen- oder Blattfeder ist.

6. Klemmenblock nach einem der Ansprüche 1 - 5, dadurch gekennzeichnet, daß das erste Kontaktelement (12, 12a, 12b) mit dem dritten Anschluß (9) verbunden ist.

7. Klemmenblock nach einem der Ansprüche 1 - 6, dadurch gekennzeichnet, daß eines der beiden Kontaktelemente, vorzugsweise das zweite Kontaktelement (11) verstellbar, vorzugsweise verschwenkbar derart vorgesehen ist, daß es durch Verstellen oder Verschwenken außer Eingriff mit dem anderen Kontaktelement gebracht werden kann,
wobei das verschwenkbare Kontaktelement (11) vorzugsweise durch eine Schraube (11') gesichert ist.

8. Klemmenblock nach einem der Ansprüche 1 - 7, dadurch gekennzeichnet, daß die Anschlüsse (7, 8) der Stromklemme in einer ersten Achsrichtung (X-Achse) am Klemmenblock (1) gegeneinander versetzt vorgesehen sind, daß der Anschluß (9) der Spannungsklemme in einer zweiten, senkrecht zur ersten Achsrichtung verlaufenden Achsrichtung (Y-Achse) gegenüber der Stromklemme (7, 8) versetzt am Klemmenblock (1) vorgesehen ist, und daß das erste Kontaktelement (12) mit seinem freien Ende mit einer in einer dritten Achsrichtung (Z-Achse) wirkenden Federkraft gegen die Anlagefläche des zweiten Kontaktes (11) anliegt, wobei die dritte Achsrichtung (Z-Achse) senkrecht zur ersten und auch senkrecht zur zweiten Achsrichtung liegt.

9. Klemmenblock nach einem der Ansprüche 1 - 7, dadurch gekennzeichnet, daß die Anschlüsse (7, 8) der Stromklemme in einer ersten Achsrichtung (X-Achse) am Klemmenblock (1) gegeneinander versetzt vorgesehen sind, daß der Anschluß (9) der Spannungsklemme in einer zweiten, senkrecht zur ersten Achsrichtung verlaufenden Achsrichtung (Y-Achse) gegenüber der Stromklemme (7, 8) versetzt am Klemmenblock (1) vorgesehen ist, und daß das erste Kontaktelement (12a, 12b) mit seinem freien Ende gegen eine in einer dritten Achsrichtung (Z-Achse) wirkende Federkraft durch ein Fixierelement, vorzugsweise durch eine Schraube (21, 23) gegen die Anlagefläche des zweiten Kontaktes (18, 26) anliegt, wobei die dritte Achsrichtung (Z-Achse) senkrecht zur ersten und auch senkrecht zur zweiten Achsrichtung liegt.

10. Klemmenblock nach einem der vorhergehenden Ansprüche, dadurch gekennzeichnet, daß ein Kontaktelement (11, 12b) in einer Ebene schwenkbar ist, die durch die erste und zweite Achsrichtung (X-Achse, Y-Achse) definiert ist.

11. Klemmenblock nach einem der vorhergehenden Ansprüche, gekennzeichnet durch ein vorzugsweise von einer Schraube (21, 23) gebildetes Fixierelement zum Andrücken des federnden Kontaktelementes (12a, 12b) gegen das zweite Kontaktelement (18, 26) bei einem gleichzeitigen elastischen Spannen des ersten Kontaktelementes (12a, 12b).

12. Klemmenblock nach einem der vorhergehenden Ansprüche, dadurch gekennzeichnet, daß das erste Kontaktelement (12b) blattfederartig ausgeführt ist und an einem Ende schwenkbar an einer das Fixierelement bildenden Schraube (23) gehalten ist und am anderen Ende eine Kontaktfläche (24) bildet, die mit einer Kontaktfläche (25) des zweiten Kontaktelementes (26) zusammenwirkt, und daß der gegen das erste Kontaktelement (12b) anliegende Schraubenkopf und/oder das erste Kontaktelement so ausgeführt sind, daß beim Lösen der Schraube (23) das erste Kontaktelement für ein Lösen oder Öffnen der Kontaktbrücke und beim Festziehen der Schraube für ein Schließen der Kontaktbrücke mitgeschwenkt wird, und daß wenigstens ein Anschlag (28) vorgesehen ist, der die Schwenkbewegung des ersten Kontaktelementes (12b) auf einen für das Lösen und Schließen der Kontaktbrücke benötigten Schwenk-Winkelbereich begrenzt.

13. Klemmenblock nach einem der vorhergehenden Ansprüche, dadurch gekennzeichnet, daß die lösbare Kontaktbrücke ein stab- oder zylinderförmiges Kontaktelement (12e, 12d) aus elektrisch leitendem Material ist.

## Claims

1. Terminal block for electricity meter, with at least one terminal arrangement (4), which has a current terminal (7, 8) for connecting the meter to a conductor of a phase of an electrical main circuit, as well as for connecting a current path (2) of a measuring device of the meter, and a voltage terminal (9) for connecting a current path of the measuring device, with the voltage terminal (9) being connected with the current terminal (7, 8) via a detachable contact bridge (11, 18, 26, 12, 12a, 12b, 12c, 12d, 12e) which is accessible from a frontal face (17) of the terminal block,
characterised in that
the detachable contact bridge has at least one contact element (12, 12a, 12b, 12c, 37, 36, 41, 43) which is designed as a spring element

2. Terminal block in accordance with claim 1, characterised in that the detachable contact bridge is formed of at least one first contact element (12, 12a, 12b), which is designed as a spring element, this contact element resting with its free end against a contact face provided on a second contact element (11, 18, 26), with one of the two contact elements (11, 18, 26, 12, 12a, 12b) being connected with the current terminal (7, 8) and the other contact element being connected with the voltage terminal (9).

3. Terminal block in accordance with claim 1 or 2, characterised in that the first contact element (12, 12c) designed as a spring element, rests against a contact face (11, 35) facing away from the frontal face (17) of the terminal block (1).

4. Terminal block in accordance with claim 1 or 2, characterised in that the first contact element (12a, 12b), designed as a spring element, rests against a contact face facing towards the front face (17) of the terminal block (1).

5. Terminal block in accordance with one of the claim 1-4, characterised in that the first contact element (12, 12a, 12b, 12c) is designed in the manner of a bowed spring, or is a bow spring or leaf spring.

6. Terminal block in accordance with one of the claims 1-5, characterised in that the first contact element (12, 12a, 12b) is connected with the third connection (9).

7. Terminal block in accordance with one of the claims 1-6, characterised in that one of the two contact elements, preferably the second contact element (11), is provided so as to be adjustable, preferably in a pivoting manner, such that via displacement or pivoting, it can be disengaged from the other contact element, with the pivoting contact element (11) being preferably secured by means of a screw (11¹).

8. Terminal block in accordance with one of the claims 1-7, characterised in that the connections (7, 8) of the current terminal are provided offset relative to one another on the terminal block (1) in a first axis direction (x-axis); that the connection (9) of the voltage terminal is provided offset relative to the current terminal (7, 8) on the terminal block (1) in a second axis direction (y-axis) running perpendicular to the first axial direction; and that the first contact element (12) rests with its free end, with a spring force acting on a third axis direction (z-axis), against the bearing surface of the second contact (11) with the third axis direction (z-axis) lying perpendicular to the first axis direction, as well as perpendicular to the second.

9. Terminal block in accordance with one of the claims 1-7, characterised in that the connections (7, 8) of the current terminal are provided offset relative to one another on the terminal block (1) in a first axis direction (x-axis); that the connection (9) of the voltage terminal is provided offset relative to the current terminal (7, 8) on the terminal block (1) in a second axis direction (y-axis) running perpendicular to the first axial direction; and that the first contact element (12a, 12b) rests with its free end, against a spring force acting in a third axis direction (z-axis) through a fixing element, preferably through a screw (21, 23), against the bearing surface of the second contact (18, 26), with the third axis direction (z-axis) lying perpendicular to the first axis direction, as well as perpendicular to the second.

10. Terminal block in accordance with one of the preceding claims, characterised in that a contact element (11, 12b) can be pivoted in one plane, which is defined by the first and second axis directions (x-axis, Y-axis).

11. Terminal block in accordance with one of the preceding claims, characterised by a fixing element, preferably a screw (21, 23) for pressing the springy contact element (12a, 12b) against the second contact element (18,26), whilst simultaneously flexibly tensing the first contact element (12a, 12b).

12. Terminal block in accordance with one of the preceding claims, characterised in that the first contact element (12b) is designed in the manner of a leaf spring, and on one end is held pivotally on a screw (23) forming the fixing element, and on the other end forms a contact face (24), which acts in conjunction with a contact face (25) of the second contact element (26); and that the screw head resting against the first contact element (12b), and/or the first contact element, are designed in such a way that the first contact element is pivoted along with the screw (23) when it is loosened, to release or open the contact bridge, and also when the screw is tightened, to close the contact bridge; and that at least one limit stop (28) is provided, which limits the pivot movement of the first contact element (12b) to such a pivot angle range as is required for releasing and closing the contact bridge.

13. Terminal block in accordance with one of the preceding claims, characterised in that the detachable contact bridge is a rod shaped or cylindrical contact element (12c, 12d) of electrically conductive material.

## Revendications

1. Répartiteur pour compteur électrique, comprenant au moins un montage de connexions (4) qui présente un contact électrique (7, 8) pour connecter le compteur à un conducteur d'une phase d'un réseau d'alimentation et pour connecter une ligne de courant (2) d'un élément de mesure du compteur, ainsi qu'un contact de tension (9) pour connecter une ligne de courant de l'élément de mesure, le contact de tension (9) étant relié au contact électrique (7, 8) par l'intermédiaire d'un pont de contact (11, 18, 26, 12, 12a, 12b, 12c, 12d, 12e) séparable, accessible par une face avant (17) du répartiteur, caractérisé en ce que le pont de contact séparable présente au moins un élément de contact (12, 12a, 12b, 12c, 37, 41, 43) conçu comme un élément à ressort.

2. Répartiteur suivant la revendication 1, caractérisé en ce que le pont de contact séparable est formé d'au moins un premier élément de contact (12, 12a, 12b) conçu comme un élément à ressort, lequel prend appui par son extrémité libre contre une surface de contact prévue sur un deuxième élément de contact (11, 18, 26), l'un des deux éléments de contact (11, 18, 26, 12, 12a, 12b) étant relié au contact électrique (7, 8) et l'autre élément de contact étant relié au contact de tension (9).

3. Répartiteur suivant la revendication 1 ou 2, caractérisé en ce que le premier élément de contact (12a, 12b) conçu comme un élément à ressort prend appui sur une surface de contact (11, 35) opposée à la face avant (17) du répartiteur (1).

4. Répartiteur suivant la revendication 1 ou 2, caractérisé en ce que le premier élément de contact (12a, 12b) conçu comme un élément à ressort prend appui sur une surface de contact tournée vers la face avant (17) du répartiteur (1).

5. Répartiteur suivant l'une quelconque des revendications 1 à 4, caractérisé en ce que le premier élément de contact (12, 12a, 12b, 12c) est construit à la manière d'un ressort en arc ou est un ressort en arc ou un ressort à lames.

6. Répartiteur suivant l'une quelconque des revendications 1 à 5, caractérisé en ce que le premier élément de contact (12, 12a, 12b) est relié à la troisième borne (9).

7. Répartiteur suivant l'une quelconque des revendications 1 à 6, caractérisé en ce que l'un des deux éléments de contact, de préférence le deuxième élément de contact (11) est prévu de manière réglable, de préférence de manière à pouvoir pivoter, de telle sorte que, par réglage ou par pivotement, il puisse être séparé de l'autre élément de contact, l'élément de contact (11) pouvant pivoter étant de préférence fixé par une vis (11').

8. Répartiteur suivant l'une quelconque des revendications 1 à 7, caractérisé en ce que les bornes (7, 8) du contact électrique sont prévues en décalage l'une par rapport à l'autre dans une première direction axiale (axe des X) sur le répartiteur (1), en ce que la borne (9) du contact de tension est prévue sur le répartiteur (1) en décalage par rapport au contact électrique (7, 8) dans une deuxième direction axiale (axe des Y) perpendiculaire à la première direction axiale, et en ce que le premier élément de contact (12) prend appui par son extrémité libre contre la surface d'appui du deuxième élément de contact (11) grâce à une force de ressort agissant dans une troisième direction axiale (axe des Z), la troisième direction axiale (axe des Z) étant perpendiculaire à la première direction axiale et aussi perpendiculaire à la deuxième direction axiale.

9. Répartiteur suivant l'une quelconque des revendications 1 à 7, caractérisé en ce que les bornes (7, 8) du contact électrique sont prévues en décalage l'une par rapport à l'autre dans une première direction axiale (axe des X) sur le répartiteur (1), en ce que la borne (9) du contact de tension est prévue sur le répartiteur (1) en décalage par rapport au contact électrique (7, 8) dans une deuxième direction axiale (axe des Y) perpendiculaire à la première direction axiale, et en ce que le premier élément de contact (12a, 12b) prend appui par son extrémité libre sur la surface d'appui du deuxième élément de contact (18, 26) grâce à un élément de fixation, de préférence une vis (21, 23), contre une force de ressort agissant dans une troisième direction axiale (axe des Z), la troisième direction axiale (axe des Z) étant perpendiculaire à la première direction axiale et aussi perpendiculaire à la deuxième direction axiale.

10. Répartiteur suivant l'une quelconque des revendications précédentes, caractérisé en ce qu'un élément de contact (11, 12b) peut pivoter dans un plan défini par la première et la deuxième directions axiales (axe des X et axe des Y).

11. Répartiteur suivant l'une quelconque des revendications précédentes, caractérisé par un élément de fixation présentant de préférence la forme d'une vis (21, 23) et destiné à presser l'élément de contact à ressort (12a, 12b) contre le deuxième élément de contact (18, 26) lors d'une tension élastique simultanée du premier élément de contact (12a, 12b).

12. Répartiteur suivant l'une quelconque des revendications précédentes, caractérisé en ce que le premier élément de contact (12b) est construit à la manière d'un ressort à lames et est, par une extrémité, maintenu pivotant sur une vis (23) formant l'élément de fixation et forme, par l'autre extrémité, une surface de contact qui coopère avec une surface de contact (25) du deuxième élément de contact (26), et en ce que la tête de vis prenant appui contre le premier élément de contact (12b) et/ou le premier élément de contact sont conçus de telle sorte que, lors du desserrage de la vis (23), le premier élément de contact soit amené à pivoter pour un détachage ou une ouverture du pont de contact et que, lors du serrage de la vis il soit amené à pivoter pour une fermeture du pont de contact, et en ce qu'il est prévu au moins une butée (28) qui limite le pivotement du premier élément de contact (12b) à une zone d'angle de pivotement requise pour le détachage et la fermeture du pont de contact.

13. Répartiteur suivant l'une quelconque des revendications précédentes, caractérisé en ce que le pont de contact séparable est un élément de contact (12e, 12d) en forme de tige ou de cylindre fait en une matière conductrice de l'électricité.
